# EUROPEAN PATENT APPLICATION

(11) **EP 2 148 369 A1**
(43) Date of publication of application: **27.01.2010**
(21) Application number: 09160945.3
(22) Date of filing: 22.05.2009
(51) Int. Cl.: H01L 25/075, H01L 33/00

(54) **LED Base Structure with enhanced light-mixing effect**

(30) Priority: 25.07.2008 TW 97213256 U; 22.09.2008 TW 97217099 U
(71) Applicant: Bi Chi Corporation, Ping Cheng City T'ao yuan 32454 (TW)
(72) Inventor: Lee, Yuan Fu, 32454, Taoyuan County (TW)
(74) Representative: Lang, Christian

(57) **Abstract**

An LED (Light-Emitting Diode) base structure (20) with enhanced light-mixing effect includes a lead frame (30) and a main body (40). The lead frame (30) has plural pins (31) each having a first end portion (311) and a second end portion (312). The main body (40) is coupled to the lead frame (30) and formed with a cup-shaped cavity (41). Each of the pins (31) has its first end portion (311) exposed in the cup-shaped cavity (41) and its second end portion (312) extended out of the main body (40). The LED base structure (20) is **characterized in that** the cup-shaped cavity (41) has a depth (D) greater than 0.8 mm so as to increase a reflective area of the cup-shaped cavity (41). Thus, light emitted from LEDs (14) mounted in the LED base structure (20) is allowed to mix sufficiently in the cup-shaped cavity (41) to produce enhanced light-mixing effect.

## Description

### Field of the Invention

The present invention relates to an LED (Light-Emitting Diode) base structure with enhanced light-mixing effect. More particularly, the present invention relates to an LED base structure configured for enhancing the light-mixing effect of LEDs that emit light of different colors.

### Background of the Invention

Recently, LEDs have found application in a diversity of fields. For example, LEDs are used in backlight modules of display devices as well as in general lighting. In order to broaden the application of LEDs, it is generally desired to increase the light-emitting efficiency and light-mixing effect of LEDs. Therefore, it is a target for the LED-related industry to improve the design of an LED base structure so as to further enhance the light-emitting efficiency and light-mixing effect of LEDs.

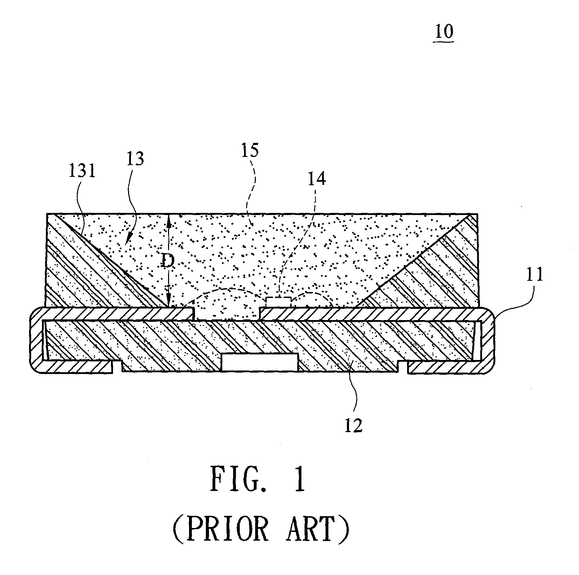

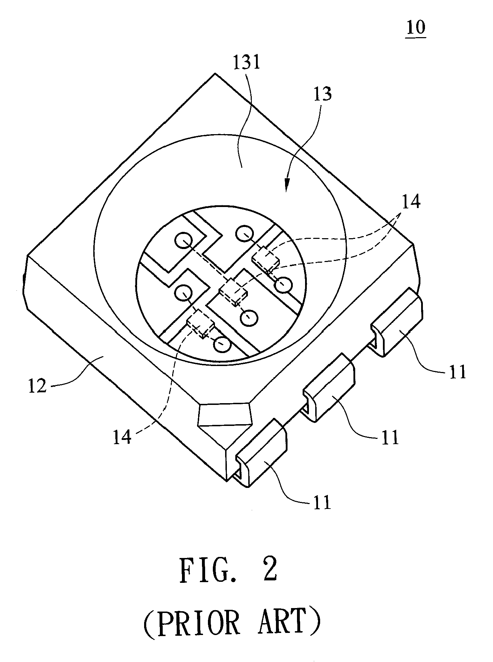

Fig. 1 and Fig. 2 show a sectional view and a perspective view of a conventional LED base structure 10, respectively. As shown in Fig. 1, the conventional LED base structure 10 includes at least two pins 11 and a main body 12. The pins 11 are bilaterally provided on the main body 12. Each pin 11 has one end portion exposed in a cup-shaped cavity 13 formed in the main body 12 and an opposite end portion extended to an appropriate location outside the main body 12 so as to serve as an electrical contact in subsequent manufacturing processes. As shown in Fig. 2, the pins 11 are isolated from one another by the main body 12 and are also insulated thereby. At least one of the pins 11 is mounted with an LED 14 and is electrically connected to the LED 14 by wire bonding so that voltage applied to the at least one pin 11 drives the LED 14 to emit light.

However, referring to Fig. 1, when a plurality of LEDs 14 are mounted in the cup-shaped cavity 13, whose depth D is rather small and ranges approximately from 0.4 mm to 0.8 mm, and which has an inclined surface 131 of a very small area, light emitted by the LEDs 14 will not be reflected repeatedly and efficiently by the inclined surface 131. In consequence, light emitted by the LEDs 14 does not mix sufficiently nor project effectively in a direction normal to the conventional LED base structure 10. As a result, the LEDs 14 do not look as bright as expected. In particular, when the LEDs 14 mounted in the conventional LED base structure 10 are capable of emitting light of different colors, the shallowness of the cup-shaped cavity 13 tends to prevent light emitted by the multi-color LEDs 14 from mixing sufficiently in the cup-shaped cavity 13.

Besides, the LEDs 14 are packaged, or encapsulated, by filling the cup-shaped cavity 13 with a packaging gel 15. However, the cup-shaped cavity 13 of the conventional LED base structure 10 is too shallow to enable easy control of the dispensing amount of the packaging gel 15 during the gel dispensing process. Hence, gel overflow is likely, and a high defective rate of the gel dispensing process ensues.

### Summary of the Invention

It is an objective of the present invention to provide an LED base structure with enhanced light-mixing effect, wherein the LED base structure has a cup-shaped cavity of increased depth to improve light mixing, enhance brightness, and lower the defective rate of the gel dispensing process.

To achieve the foregoing objective, the present invention provides an LED base structure capable of producing enhanced light-mixing effect, wherein the LED base structure includes a lead frame and a main body. The lead frame has a plurality of pins each having a first end portion and a second end portion. The main body is coupled to the lead frame and formed with a cup-shaped cavity. In each pin, the first end portion is exposed in the cup-shaped cavity while the second end portion is extended out of the main body. The LED base structure is **characterized in that** the cup-shaped cavity has a depth greater than 0.8 mm.

Implementation of the present invention at least involves the following inventive steps:
1. The depth of the cup-shaped cavity is increased so as to enlarge the area of an inclined surface of the cup-shape cavity and thereby improve the light-mixing effect of LEDs mounted in the LED base structure.
2. The depth of the cup-shaped cavity is increased so as to augment a receiving space in the cup-shaped cavity and thereby prevent a packing gel from overflowing.
3. The increased depth of the cup-shaped cavity allows the LEDs mounted therein to exhibit enhanced brightness suitable for outdoor applications.

### Brief Description of the Drawings

A detailed description of further features and advantages of the present invention is given below so that a person skilled in the art is enabled to understand and implement the technical contents of the present invention and readily comprehend the objectives and advantages thereof by reviewing the teachings disclosed herein and the appended claims in conjunction with the accompanying drawings in which:
Fig. 1 is a sectional view of a conventional LED base structure;
Fig. 2 is a perspective view of the conventional LED base structure;
Fig. 3 is a perspective view of an LED base structure with enhanced light-mixing effect according to the present invention;
Fig. 4 is a top view of the LED base structure with enhanced light-mixing effect according to the present invention; and
Fig. 5 is a sectional view of the LED base structure with enhanced light-mixing effect according to the present invention.

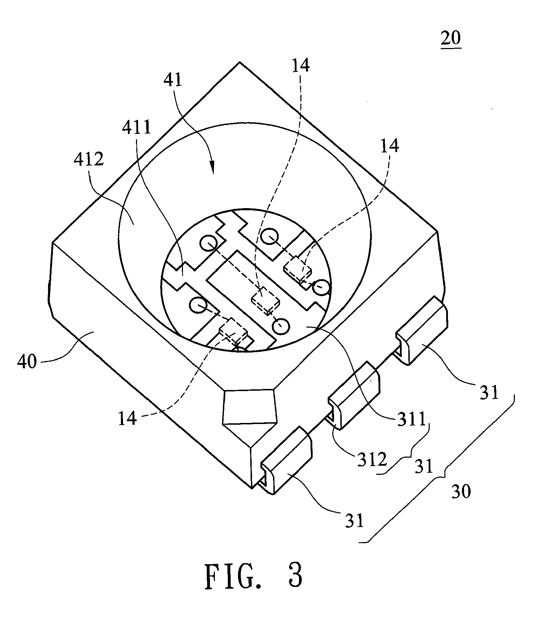

Referring to Fig. 3, an LED base structure 20 with enhanced light-mixing effect according to an embodiment of the present invention includes a lead frame 30 and a main body 40.

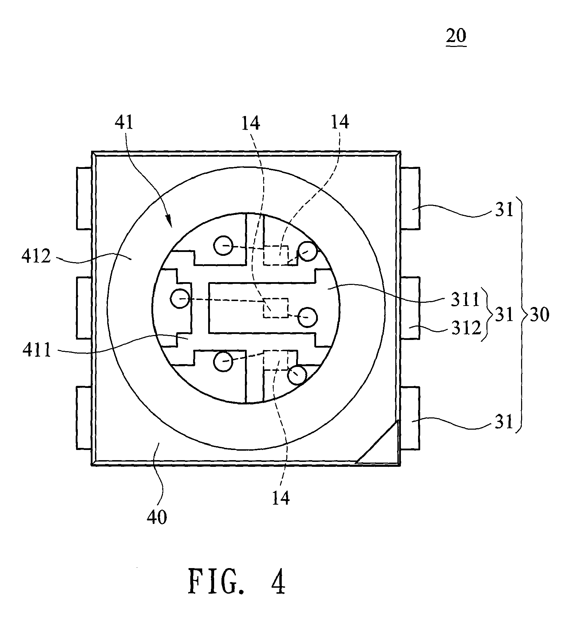

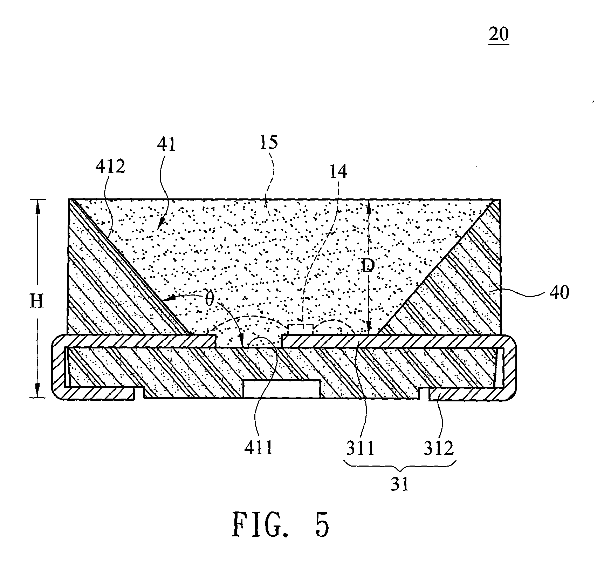

As shown in Fig. 4, the lead frame 30 has a plurality of pins 31. As shown more clearly in Fig. 5, each pin 31 has a first end portion 311 and a second end portion 312. The lead frame 30 is a metal frame configured for supporting LEDs 14 in the LED base structure 20.

Referring to Fig. 5, the main body 40 is coupled to the lead frame 30 and formed with a cup-shaped cavity 41. The main body 40 has a total height H ranging from 2 mm to 3.6 mm or preferably from 2.3 mm to 3.3mm. More preferably, the total height H of the main body 40 ranges from 2.69 mm to 2.79 mm. The main body 40 is made of engineering plastic, copper, ceramic, or a silicon chip. For instance, the main body 40 is injection-molded from engineering plastic, or stamped from a copper column, or formed by co-firing multiple layers of ceramic, or made of a silicon chip that is etched to form the cup-shaped cavity 41. Now that the silicon chip employed can be a waste silicon chip that is no longer good for use as an integrated circuit, the LED base structure 20 may have its production cost significantly reduced if the main body 40 is made of a waste silicon chip.

As shown in Figs. 3 and 4, the cup-shaped cavity 41 has a first surface 411 and a second surface 412. The first surface 411 is a bottom surface of the cup-shaped cavity 41 while the second surface 412 is an inclined surface of the cup-shaped cavity 41 and connected with the first surface 411. As shown in Fig. 5, the first surface 411 and the second surface 412 jointly form a first included angle θ, which ranges from 35° to 55°, preferably from 40° to 50°, or more preferably from 43° to 47°, so that light emitted by the LEDs 14 is properly reflected by the second surface 412.

As shown in Figs. 3 and 4, the first end portion 311 of each pin 31 is exposed in the cup-shaped cavity 41, thus allowing the LEDs 14 to be mounted on the first end portions 311 and electrically connected to the pins 31 of the lead frame 30 by wire bonding. On the other hand, the second end portion 312 of each pin 31 is extended out of the main body 40 or, more particularly, extended to a lateral side and a bottom of the main body 40 so as to serve as an electrical contact in subsequent manufacturing processes.

For example, referring again to Fig. 3, the lead frame 30 has six pins 31, and the first end portions 311 of the six pins 31 are electrically isolated from one another by the main body 40. Thus, LEDs 14 of various colors can be mounted on the first end portions 311 of different pins 31 and be driven respectively to emit light of various colors by current inputted to the second end portions 312 of the different pins 31. The light emitted by the LEDs 14 is mixed in the cup-shaped cavity 41 before being projected outward.

Referring to Fig. 5, in order to provide the LEDs 14 with enhanced light-mixing effect, the cup-shaped cavity 41 of the main body 40 is configured with a depth D greater than 0.8 mm so as to increase the area of the second surface 412 of the cup-shaped cavity 41 and thereby increase the reflective area for reflecting the light emitted by the LEDs 14. Hence, light emitted by the LEDs 14 is sufficiently mixed in the cup-shaped cavity 41 before being projected outward and stray light around the light field of the LEDs 14 is reduced as a result. To further enhance the light-mixing effect, the depth D of the cup-shaped cavity 41 is set between 1.7 mm and 2.6 mm or preferably between 1.73 mm and 1.83 mm. More preferably, the depth D of the cup-shaped cavity 41 is set between 1.75 mm and 1.81 mm. By doing so, not only is the light-mixing effect improved for the LEDs 14 of different colors, but also the light-emitting efficiency of a white light production process, as applicable, is increased by approximately 10%.

Also, a receiving space in the cup-shaped cavity 41 is increased with the depth D of the cup-shaped cavity 41. Therefore, during a further gel dispensing process in which a packaging gel 15 is filled into the cup-shaped cavity 41 to encapsulate the LEDs 14, the dispensing amount of the packaging gel 15 can be easily controlled, thereby preventing gel overflow as well as lowering the defective rate of the gel dispensing process. Besides, since the cup-shaped cavity 41 is configured for allowing the LEDs 14 to exhibit enhanced brightness, application of the LEDs 14 can be extended, such as to outdoor bulletin boards, outdoor illumination, and so on.

The present invention has been described by reference to the preferred embodiment, and it is understood that the embodiment is intended to enable a person skilled in the art to understand and implement the contents disclosed herein, but is not intended to limit the scope of the present invention. Therefore, all equivalent modifications or changes which do not depart from the concept of the present invention should be encompassed by the appended claims.

## Claims

1. An LED (Light-Emitting Diode ) base structure with enhanced light-mixing effect, comprising a lead frame (30) having a plurality of pins (31) each having a first end portion (311) and a second end portion (312), and a main body (40) coupled to the lead frame (30) and formed with a cup-shaped cavity (41), wherein the first end portion (311) of each said pin (31) is exposed in the cup-shaped cavity (41), and the second end portion (312) of each said pin (31) is extended out of the main body (40), the LED base structure being **characterized in that** the cup-shaped cavity (41) has a depth (D) greater than 0.8 mm.

2. The LED base structure according to Claim 1, wherein the lead frame (30) has six said pins (31), and the first end portions (311) of the six pins (31) are electrically isolated from one another by the main body (40).

3. The LED base structure according to Claim 1, wherein the second end portion (312) of each said pin (31) is extended to a lateral side of the main body (40) and a bottom of the main body (40).

4. The LED base structure according to Claim 1, wherein the main body (40) is made of engineering plastic, copper, ceramic, or a silicon chip.

5. The LED base structure according to Claim 1, wherein the depth (D) of the cup-shaped cavity (41) ranges from 1.7 mm to 2.6 mm.

6. The LED base structure according to Claim 1, wherein the depth (D) of the cup-shaped cavity (41) ranges from 1.73 mm to 1.83 mm.

7. The LED base structure according to Claim 1, wherein the depth (D) of the cup-shaped cavity (41) ranges from 1.75 mm to 1.81 mm.

8. The LED base structure according to Claim 1, wherein the main body (40) has a total height (H) ranging from 2 mm to 3.6 mm.

9. The LED base structure according to Claim 1, wherein the main body (40) has a total height (H) ranging from 2.3 mm to 3.3 mm.

10. The LED base structure according to Claim 1, wherein the main body (40) has a total height (H) ranging from 2.69 mm to 2.79 mm.

11. The LED base structure according to Claim 1, wherein the cup-shaped cavity (41) has a first surface (411) and a second surface (412), the first surface (411) and the second surface (412) jointly forming a first included angle (θ).

12. The LED base structure according to Claim 11, wherein the first included angle (θ) ranges from 35° to 55°.

13. The LED base structure according to Claim 11, wherein the first included angle (θ) ranges from 40° to 50°.

14. The LED base structure according to Claim 11, wherein the first included angle (θ) ranges from 43° to 47°.
